# DEMANDE DE BREVET EUROPEEN

(11) **EP 0 666 597 A1**
(43) Date de publication de la demande: **09.08.1995**
(21) Numéro de dépôt: 95470003.5
(22) Date de dépôt: 23.01.1995
(51) Int. Cl.: H01L 27/02

(54) **Procédé de réalisation d'un transistor bipolaire pour protection d'un circuit intégré contre les décharges électrostatiques**

(30) Priorité: 28.01.1994 FR 9400951
(71) Demandeur: SGS-THOMSON MICROELECTRONICS S.A., F-94250 Gentilly (FR)
(72) Inventeur: Tailliet, François , Cabinet Ballot Schmit, F-57000 Metz (FR)
(74) Mandataire: Schmit, Christian Norbert Marie

(57) **Abrégé**

L'invention concerne un procédé de réalisation d'un transistor bipolaire latéral. Dans le procédé suivant l'invention, on évite la formation d'une couche d'oxyde de champ à la surface du substrat, entre le collecteur et l'émetteur du transistor de protection. Les transistors bipolaires latéraux réalisés suivant l'invention sont avantageusement utilisés pour la protection de circuits Intégrés de type MOS contre les décharges électrostatiques.

## Description

L'invention concerne un procédé de réalisation d'un transistor bipolaire de protection contre des décharges électrostatiques dans un circuit intégré.

Les circuits intégrés en général sont très sensibles aux décharges électrostatiques. En effet ces décharges se traduisent par des surtensions de durées brèves, mais de valeurs élevées, pouvant atteindre plusieurs kilovolts en tension crête, et induire des puissances dissipées instantanées de plusieurs dizaines de Watts. Ces décharges électrostatiques sont susceptibles de dégrader le fonctionnement des circuits intégrés, voire de détruire ces circuits, par exemple par échauffement excessif. Il est donc primordial de se prémunir contre ce type de phénomène, en plaçant en entrée des circuits intégrés des dispositifs de protection.

Une première protection a consisté à connecter, entre des points d'entrées de circuits intégrés et des bornes d'alimentation de ces circuits intégrés, des diodes d'écrêtage. Cette solution présente notamment l'inconvénient d'être restrictive, les tensions de seuil de ces diodes limitant l'échelle des valeurs admises au niveau de ces points d'entrée, en fonctionnement normal.

On se tourne donc de plus en plus vers un deuxième dispositif de protection à transistor bipolaire.

Considérons par exemple que le dispositif de protection concerne un circuit intégré alimenté entre une tension positive et une masse, ayant une entrée, et qu'on souhaite le protéger contre des décharges électrostatiques de tensions positives.

On protège le circuit intégré en connectant un transistor bipolaire de type NPN entre son entrée et la masse. Le collecteur est connecté à l'entrée du circuit intégré. La base et l'émetteur sont connectés à la masse. Le transistor est donc bloqué en l'absence de décharge électrostatique. On suppose en effet que les valeurs de tension autorisées par le constructeur en entrée du circuit sont inférieures à la valeur de tension d'avalanche du transistor bipolaire de protection. En cas de décharge électrostatique, le transistor de protection écrête la surtension caractérisant cette décharge. En effet, la surtension provoque un phénomène d'avalanche dans le transistor de protection.

D'un point de vue technologique, on réalise notamment les circuits intégrés en technologie Métal-Oxyde-Semiconducteur (MOS).

En ce qui concerne la réalisation de la protection de circuits intégrés de type MOS à l'aide de transistors bipolaires, on ne souhaite pas réaliser de circuits bipolaires à couches superposées. Effectivement, ce type de réalisation est plus complexe, du point de vue du nombre d'opérations à effectuer, que la réalisation de circuits de type MOS. On a donc cherché à intégrer la réalisation des transistors bipolaires de protection dans le processus de réalisation des circuits de type MOS qu'ils protègent. Cela permet de ne pas imposer des étapes supplémentaires de diffusion par rapport à celles que nécessite la réalisation d'un circuit de type MOS. De ce fait, on réalise de préférence des transistors bipolaires de type latéral pour la protection des circuits.

Le procédé de réalisation d'un transistor bipolaire latéral, de type NPN dans l'exemple choisi, comprend typiquement les opérations de base suivantes :
- élaboration d'un substrat de type P,
- création à la surface du substrat d'une couche d'oxyde de champ par oxydation thermique, cette couche délimitant deux zones d'implantation de type source/drain,
- implantation de dopants de type N au niveau des zones d'implantation et diffusion de ces dopants dans le substrat semi-conducteur sous-jacent,
- dépôt en phase vapeur d'une couche isolante sur le circuit,
- ouverture de contacts au niveau des zones d'implantation,
- métallisation des contacts.

Les zones d'implantation sont des zones dites actives. Une zone active est une zone superficielle du substrat couverte d'oxyde mince. Une telle zone active est donc susceptible d'être dopée par implantation. Par la suite, le terme zone d'implantation caractérisera les zones actives effectivement implantées lors du processus de réalisation. Dans l'exemple, les zones d'implantation, ou actives, forment, avec leur diffusion sous-jacente de type N, l'émetteur et le collecteur (ci-dessous dénommées électrodes) du transistor bipolaire de protection.

La base du transistor bipolaire est constituée par le substrat, ce dernier étant connecté à la masse. Pratiquement, la base utile du transistor est la partie du substrat située entre les diffusions de type N de l'émetteur et du collecteur. On appelle base utile la zone de base intervenant dans l'effet transistor.

Les zones d'implantation sont délimitées par l'oxyde de champ à la surface du substrat. En effet, l'oxyde de champ s'oppose au passage des particules dopantes. Il isole donc le substrat lors des opérations de dopage. Les zones d'implantation sont caractérisées en ce qu'elles ne sont pas couvertes par l'oxyde de champ.

La réalisation de l'implantation et de la diffusion de dopants de type N au niveau des zones d'implantation s'intègre dans le processus de réalisation d'un circuit de type MOS. Il n'y a pas empilement de trois couches dopées successivement N, P et N.

On peut, avant la création de l'oxyde de champ, procéder à une implantation et à une diffusion de type P au niveau des zones que couvrira l'oxyde de champ. On crée ainsi, par diffusion, des murs d'isolation (channel stop en littérature anglo-saxonne) entre l'émetteur et le collecteur d'une part, et entre ces électrodes et le reste du circuit d'autre part. Comme le substrat est de type P au départ, les concentrations d'impuretés dans les caissons d'isolation sont bien sûr supérieures à celle du substrat.

Les caissons d'isolation permettent d'éviter un perçage du transistor, c'est à dire un passage de courant de fuite entre les électrodes. D'autre part, ces diffusions d'isolement permettent de diminuer la formation de transistors de type MOS parasites, dont les grilles seraient constituées par des interconnexions passant au dessus des zones d'implantation.

Ce type de procédé présente un inconvénient. En effet, il est apparu qu'après une décharge électrostatique, des courants de fuite pouvaient apparaître, en fonctionnement normal, entre le collecteur et la base. On entend, par fonctionnement normal, un fonctionnement qui n'induise pas de conduction dans le transistor bipolaire de protection.

On a découvert que ces fuites de courant sont dues à l'injection de porteurs chauds dans l'oxyde de champ qui sépare les électrodes, de manière analogue au phénomène de vieillissement des transistors de type MOS. Cette injection se produit dans une région de l'oxyde de champ dite "bec d'oiseau". Un bec d'oiseau est une particularité, en forme de pointe, se situant à la frontière d'un oxyde de champ et de la surface d'un substrat non oxydé thermiquement. Il est du à l'oxydation latérale de ce substrat.

On appelle porteur chaud un porteur (dans l'exemple un électron) accéléré par le champ résultant d'une décharge électrostatique et susceptible d'acquérir une énergie suffisante pour vaincre la barrière de potentiel de l'oxyde de champ. Cette injection se produit au niveau du bec d'oiseau placé à la frontière de l'oxyde de champ séparant les électrodes, et du collecteur du transistor. Cette injection reste limitée, les porteurs étant freinés dans l'oxyde de champ. Il se crée en surface de l'oxyde de champ, côté collecteur, un champ électrique qui induit un courant de fuite entre le collecteur et le substrat du transistor.

Au vu de ce qui précède, le but de la présente invention est de proposer un procédé de réalisation de transistor bipolaire latéral de protection qui permette d'éliminer les fuites de courant apparaissant en régime normal, après une décharge.

La solution que propose l'invention est d'éliminer la zone d'oxyde de champ dans laquelle se produit l'injection de porteurs chauds, induisant les fuites. Cette zone d'oxyde de champ est celle qui sépare les deux zones d'implantation correspondantes aux électrodes du transistor bipolaire. Elle recouvre donc la base utile du transistor bipolaire.

Suivant l'invention, ce but est atteint en mettant en oeuvre un procédé de réalisation d'un transistor bipolaire de protection contre des décharges électrostatiques dans un circuit intégré, comportant dans l'ordre des opérations de masquage permettant, pour ce transistor bipolaire, de délimiter en surface d'un substrat semi-conducteur deux zones d'implantation et une zone de séparation entre les dites zones d'implantation, et une opération d'implantation des zones d'implantation avec des impuretés permettant de doper sélectivement ces zones d'implantation, caractérisé en ce que les opérations de masquage comportent une première étape avec un masquage de contour global pour réaliser un oxyde de champ autour des zones d'implantation et une deuxième étape avec un masquage permettant de séparer, à l'intérieur de ce contour global, les zones d'implantation différenciées, et en ce qu'on effectue, ultérieurement à l'opération d'implantation des zones d'implantation, une opération de recouvrement d'une partie des zones d'implantation et de la zone de séparation avec un isolant déposé, cet isolant étant déposé contre la surface du substrat semi-conducteur à l'endroit de la zone de séparation.

On empêche ainsi l'injection de porteurs chauds dans le bec d'oiseau de l'oxyde de champ, au niveau de la zone de séparation des zones d'implantation, du côté du collecteur. Le bec d'oiseau a disparu à cet endroit.

La suppression de l'oxyde de champ séparant les zones d'implantation nécessite d'intervenir au niveau des masques utilisés lors des opérations d'oxydation thermiques et de dopage des zones d'implantation. En effet, la délimitation des zones d'implantation étaient précédemment obtenue par l'oxyde de champ. L'oxyde de champ couvrait la zone de séparation des zones d'implantation.

Le procédé suivant l'invention permet de doper les régions d'implantation de manière sélective, en masquant la zone de séparation de façon temporaire lors du dopage des zones d'implantation.

Ainsi, lors des opérations de masquage, on réalise un oxyde de champ ne couvrant pas les zones d'implantation et la zone de séparation entre les zones d'implantation. La zone de séparation entre les zones d'implantation est masquée temporairement lors de l'opération d'implantation des zones d'implantation, les seules zones d'implantation étant dopées lors de cette opération.

On n'a donc plus qu'une seule zone active (c'est à dire couverte d'oxyde mince) au lieu de deux précédemment. Cette zone active comprend les deux zones d'implantation et la zone de séparation entre les dites zones.

Habituellement les masques d'implantation sont générés automatiquement par un programme informatique, à partir du masque délimitant les zones actives et d'informations définissant le type de dopage (N ou P) de ces zones. Il n'est donc pas commun d'intervenir sur ces niveaux. En effet, en technologie MOS, les diffusions de même type sont soit séparées par un grille pour former un transistor MOS, soit séparées par oxyde de champ.

L'invention permet de réaliser un transistor bipolaire de protection contre des décharges électrostatiques dans un circuit intégré, comportant
- un substrat semi-conducteur implanté avec un dopant d'un premier type, dans une certaine concentration,
- une couche d'oxyde de champs recouvrant une partie du substrat semi-conducteur, la partie non recouverte formant une zone active,
- deux zones d'implantation distinctes implantées avec un dopant d'un deuxième type dans la zone active,
- une zone de séparation, dans la zone active, entre ces zones d'implantation,

caractérisé en ce qu'il comporte
- une couche d'un isolant déposé à la surface du transistor ultérieurement à l'implantation, cette couche d'isolant étant au contact d'une partie des zones d'implantation et de la zone de séparation, et en ce que l'isolant déposé est au contact du substrat semi-conducteur à l'endroit de la zone de séparation.

Dans la technologie MOS classique, l'isolant déposé est au contact de grilles de transistors de type MOS, de zones d'oxyde de champ, et de zones d'implantation.

D'autres particularités et avantages de la présente invention apparaîtront dans la description, donnée à titre indicatif et non limitatif détaillée ci-dessous d'un exemple de réalisation préféré, dans laquelle :
- les figures 1a, 1b, et 1c représentent une partie des masques utilisés dans un procédé de réalisation de transistor bipolaire latéral, suivant l'état de l'art,
- les figures 2a, 2b et 2c représentent les masques équivalents à ceux précédemment nommés, utilisés dans un procédé suivant l'invention,
- la figure 3 représente une vue en coupe d'un transistor bipolaire latéral réalisé suivant l'état de l'art,
- la figure 4 représente une vue en coupe d'un transistor bipolaire latéral réalisé suivant le procédé de l'invention.

Dans la réalisation d'un transistor bipolaire latéral de type NPN suivant l'état de l'art, on procède typiquement aux étapes suivantes :
- création à la surface d'un substrat semi-conducteur de type P d'une couche d'oxyde de champ par oxydation thermique, cette couche délimitant deux zones d'implantation,
- implantation de dopants de type N au niveau des zones d'implantation et diffusion de ces dopants dans le substrat semi-conducteur sous-jacent,
- dépôt en phase vapeur d'une couche isolante déposée sur le circuit,
- ouverture de contacts au niveau des zones d'implantation,
- métallisation des contacts.

Bien entendu, le procédé de réalisation d'un transistor nécessite un nombre d'étapes beaucoup plus important. On se limite ici à la description des étapes nécessaires à la compréhension de l'invention.

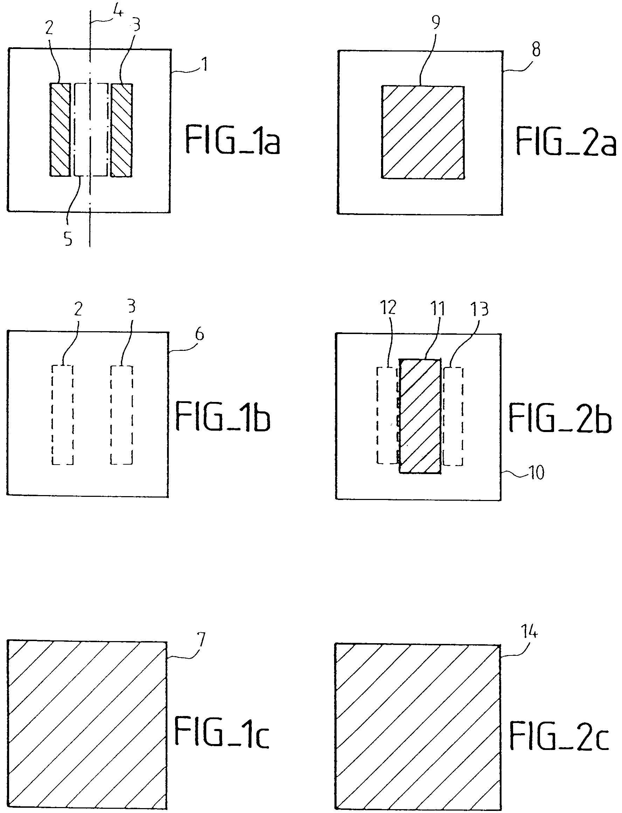

Les figures 1a, 1b, 1c, 2a, 2b et 2c représentent des masques vus de dessus. Dans ces figures :
- un masque est représenté par une géométrie carrée,
- les zones hachurées du masque représentent des zones protégées, qui ne subissent pas de modification structurelle lors de l'étape en question. En pratique, ce sont des zones recouvertes d'une couche de résine photosensible non insolée (dans le cas d'une photorésine positive), ou insolée (dans le cas d'une photorésine négative).
- les zones non hachurées sont les zones du substrat qui subissent une modification structurelle lors de l'étape en question. En pratique, ce sont des zones recouvertes d'une couche de résine photosensible insolée (dans le cas d'une photorésine positive), ou non insolée (dans le cas d'une photorésine négative).

Bien sûr, ces masques sont des parties de masques plus importants non représentés ici et utilisés pour réaliser l'ensemble d'un circuit intégré protégé par transistor bipolaire latéral contre les décharges électrostatiques. La réalisation des transistors de protection s'insère logiquement dans la réalisation du circuit intégré qu'ils protègent.

La figure 1a représente un masque 1 utilisé pour une oxydation thermique du substrat semi-conducteur d'un transistor de protection réalisé suivant l'état de l'art. Sur ce masque, deux zones rectangulaires hachurées de même dimensions 2 et 3 sont placées symétriquement par rapport à un axe fictif de symétrie 4, représenté en traits tirés, reliant les milieux de deux côtés opposés du masque 1. Les autres zones du masque sont non hachurées.

Ce premier masque 1 permet de réaliser un oxyde de champ sur l'ensemble du substrat du transistor, excepté sur les zones hachurées 2 et 3 qui formeront les zones d'implantation du transistor (émetteur et collecteur). On réalise donc deux zones actives sur la surface du substrat semi-conducteur, correspondant aux zones d'implantation 2 et 3.

Les zones d'implantation 2 et 3 ne sont pas en contact, ce qui correspondrait à court-circuiter l'émetteur et le collecteur du transistor qu'on réalise. Elles ne croisent donc pas l'axe fictif de symétrie 4. De ce fait, il existe entre les zones d'implantation 2 et 3, une zone non hachurée 5 dite de séparation. Cette zone 5 est rectangulaire, et deux de ses côtés, opposés, sont formés par les côtés symétriques des zones d'implantation 2 et 3 les plus proches de l'axe fictif de symétrie 4. Le contour de cette zone de séparation 5 est représentée en pointillés et traits tirés alternés. En pratique, cette zone de séparation 5 couvre la base utile du transistor bipolaire de protection.

Sur les schémas, pour des raisons de lisibilité, on ne respecte pas les proportions réelles d'un transistor.

En pratique, le substrat semi-conducteur du transistor bipolaire de protection occupe une surface rectangulaire de l'ordre de 200 micromètres sur 150 micromètre de côté. Les zones d'implantation sont de l'ordre de 100 micromètres sur 25 micromètres. L'axe de symétrie fictif est parallèle à leurs plus grands côtés et elles sont excentrées par rapport à l'axe d'environ 1 micromètre. Ainsi, la zone de séparation est de l'ordre de 100 micromètres sur 2 micromètres.

Le substrat semi-conducteur du transistor de protection est de type P dans l'exemple traité.

La figure 1b représente un premier masque de dopage 6 non hachuré. Ce masque de dopage 6 est utilisé pour doper les zones d'implantation 2 et 3, dont les contours sont représentés en traits tirés. Dans l'exemple considéré il s'agit du masque utilisé pour le dopage de type N de l'émetteur et du collecteur du transistor de protection. On suppose que ces zones d'implantation sont dopées avec le même dopant, hypothèse qui correspond à la réalité. Seules les zones d'implantation 2 et 3 seront dopées, les autres étant isolées par l'oxyde de champ précédemment formé à l'aide du masque 1 de la figure 1a.

La figure 1b représente un deuxième masque de dopage 7 hachuré. C'est un masque de dopage utilisé pour doper des zones d'implantation avec un dopant de type P. Dans l'exemple traité, on ne dope pas de zone d'implantation du transistor de protection avec ce type de dopant, à l'exception bien sûr du substrat semi-conducteur. On représente néanmoins ce masque, étant entendu qu'on peut avoir à doper, à un autre endroit du circuit intégré, des zones d'implantation avec un dopant type P.

Dans le procédé suivant l'invention, on modifie les masques des figures 1a et 1b.

On suppose, pour simplifier, dans la suite de la description, que la surface du transistor de protection, ainsi que l'emplacement et la surface des zones d'implantation sont identiques, que la réalisation soit conduite selon l'état de l'art ou selon l'invention.

La figure 2a représente un masque 8, dit de contour global. Ce masque de contour global 8 est un masque utilisé pour former un oxyde de champ à la surface du substrat semi-conducteur d'un transistor de protection réalisé suivant l'invention. Il correspond, dans l'invention, au masque 1 de l'état de l'art. Le masque de contour global 8 comprend une seule zone hachurée 9. Cette zone active 9 est rectangulaire et correspond à la réunion des zones d'implantation 2 et 3 et de la zone de séparation 5 telles que définies dans la figures 1a.

Ainsi, on réalise un oxyde de champ autour des zones d'implantation. Par autour des zones d'implantation on entend autour de la zone active 9 précédemment définie.

La figure 2b représente un premier masque de dopage 10, correspondant au masque 6 de la figure 1b. Il est utilisé pour un dopage de type N. Il comprend une zone hachurée 11 dite de séparation comprise entre deux zones d'implantation 12 et 13. Les zones d'implantation 12 et 13 correspondent aux zones d'implantation 2 et 3 de la figure 1a. Les contours de ces zones d'implantation 12 et 13 sont représentés en traits tirés. Elles sont rectangulaires, placées de manière similaire aux zones 2 et 3, et occupent des surfaces équivalentes à celles des zones 2 et 3. La zone de séparation 11, qui est rectangulaire, correspond à la zone de séparation 5 de la figure 1a. En pratique, comme figuré sur la figure 2b, la zone de séparation 11 occupe une surface plus importante que la zone de séparation 5 de la figure 1a. En appelant hauteur la dimension des surfaces rectangulaires qui est parallèle à l'axe fictif de symétrie 4 (voir figure 1a), la hauteur de la zone de séparation 11 est plus importante que celle de la zone de séparation 5 de la figure 1a. Ce dépassement permet de garantir parfaitement la protection des bords de la zone de séparation 11, en cas de mauvais alignement du masque de dopage 10 par rapport au masque de contour global 8. Sans cette précaution, on risquerait de n'avoir qu'une seule zone d'implantation formée de la réunion des zones d'implantations 12 et 13, et d'une partie de la zone de séparation 11. La superficie de la réunion des zones 11, 12 et 13 correspond en pratique à la superficie de la zone active 9 du masque de contour global 8, augmentée de la superficie des dépassements de la zone de séparation 11.

La figure 2c représente un deuxième masque de dopage 14, correspondant au masque 7 de la figure 1c. Ce masque de dopage 14 utilisé pour un dopage de type P. Il est identique au masque de dopage 7 de la figure 1c.

Dans l'invention, on procède comme si on allait doper la zone de séparation 11 entre les zones d'implantation 12 et 13 avec un dopant de type P. Cette zone de séparation 11 est donc protégée temporairement lors du dopage de type N des zones d'implantation 12 et 13, par exemple à l'aide d'une résine. Cette protection est poursuivie lors du dopage de type P, ce qui fait que cette zone de séparation 11 n'est finalement pas dopée, si ce n'est bien sûr en début de procédé, quand on réalise le substrat du transistor de protection.

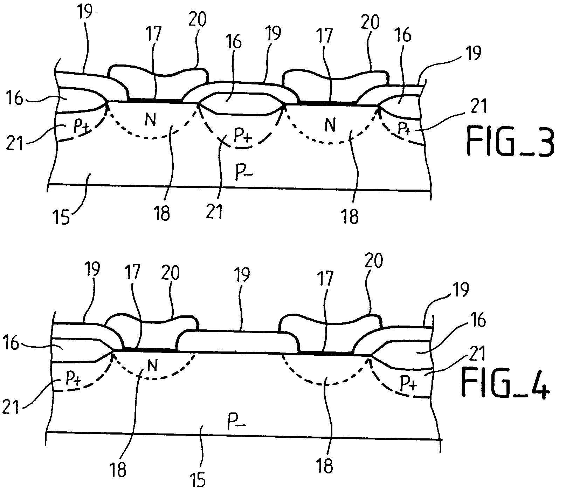

Sur la figure 3, une vue en coupe d'un transistor bipolaire de protection réalisé suivant l'état de la technique on représente :
- un substrat semi-conducteur 15 de type P-, qui est un dopage de type P avec une concentration de dopants de typiquement 10¹⁶ impuretés/cm³.
- à la surface de ce substrat semi-conducteur 15, on a formé, à l'aide du masque 1 de la figure 1a, une couche d'oxyde de champ 16 interrompue en deux zones 17 de la surface. Ces zones d'implantation 17, non couvertes d'oxyde de champ 16, correspondent à l'émetteur et au collecteur du transistor de protection. Ces zones d'implantation 17 sont dopées par diffusion d'un dopant de type N, en concentration de 10¹⁹ à 10²⁰ impuretés/cm³. Le dopage s'effectue sélectivement à l'aide du masque 10 de la figure 2b. Classiquement, après implantation en surface de dopants sur les zones d'implantation 17, il y a diffusion de ces dopants dans le substrat semi-conducteur 15 sous-jacent. On crée ainsi des diffusions de type N 18 sous les zones d'implantation 17. Les contours de ces diffusions 18 dans le substrat semi-conducteur 15 sont représentés en pointillés. En pratique, on diffuse sur une épaisseur de 0.2 à 0.3 micromètre.
- on représente ensuite une couche isolante 19, formée par dépôt sur l'ensemble des circuits. Cette couche permet en pratique d'isoler les zones d'implantation d'éventuelles interconnexions passant au dessus. Cette couche isolante 19 est interrompue au niveau d'une partie de la surface de chaque zone d'implantation 17, afin de créer des zones de contact entre les zones d'implantation et des métallisations 20. Elle ne couvre donc que l'oxyde de champ 16 et une partie des zones d'implantation. En pratique, cette couche a une épaisseur de l'ordre du micromètre.
- enfin on a représenté des zones de diffusions 21 de type P, notées P+, d'une concentration de l'ordre 10¹⁷ impuretés/cm³. Ces zones de diffusion 21, dites murs d'isolation, permettent d'éviter le perçage du transistor et l'apparition de transistors MOS parasites. Ils sont placées dans le substrat semi-conducteur 15, sous l'oxyde de champ 16. On représente leurs contours par des traits tirés. Ces murs d'isolation 21 sont de l'ordre de grandeur du micromètre de profondeur. Ils sont obtenus par diffusion de dopants après implantation de ces dopants à la surface du substrat semi-conducteur 15. La création de ces murs d'isolation 21 est bien sûr antérieure à la formation d'oxyde de champ à la surface du substrat semi-conducteur 15.

La figure 4 est équivalente à la figure 3, si ce n'est qu'on ne trouve pas d'oxyde de champ 16 entre les zones d'implantation 17. On crée, entre les zones d'implantation 17, une zone de séparation correspondant à la zone de séparation 11 de la figure 2b. Cette zone de séparation n'est pas dopée avec un dopant de type N, mais n'est pas pour autant couverte d'une couche d'oxyde de champ 16. La couche isolante 19 entre les zones d'implantation 17 est donc directement au contact du substrat semi-conducteur 15.

D'autre part, on ne trouve pas de mur d'isolation 21 entre les zones d'implantation 17. La base du transistor bipolaire latéral de protection est donc moins dopée. Cela tend à améliorer le gain en courant de ce transistor. De ce fait, on réduit l'énergie dissipée dans celui-ci par effet Joule lors d'une décharge électrostatique. Cela permet de prolonger la durée de vie de ce transistor. On pourrait éventuellement implanter un mur d'isolation 21 entre les zones d'implantation 17. Cela nécessiterait de procéder à la diffusion de dopants, pour créer ce mur d'isolation 21, avant de créer la couche d'oxyde de champ 16. Or, en pratique, on réalise les murs d'isolation 21, par chauffage, en même temps qu'on crée la couche d'oxyde de champ 16.

On a décrit ci-dessus un mode préféré de procédé pour réaliser un transistor bipolaire latéral de protection suivant l'invention.

Cet exemple n'est pas limitatif. En particulier les zones d'implantation ne sont pas nécessairement rectangulaires et/ou symétriques. Ainsi on pourra réaliser des zones d'implantation en forme de peigne par exemple. D'autre part, le procédé employé peut être utilisé pour réaliser des transistors bipolaires latéraux de type PNP.

## Revendications

**1 -** Procédé de réalisation d'un transistor bipolaire de protection contre des décharges électrostatiques dans un circuit intégré, comportant dans l'ordre
- des opérations de masquage permettant, pour ce transistor bipolaire, de délimiter en surface d'un substrat semi-conducteur deux zones d'implantation (12, 13) et une zone de séparation (11) entre les dites zones d'implantation (12, 13),
- une opération d'implantation des zones d'implantation (12, 13) avec des impuretés permettant de doper sélectivement ces zones d'implantation (12, 13),
caractérisé en ce que les opérations de masquage comportent
- une première étape avec un masquage de contour global pour réaliser un oxyde de champ autour d'une zone active (9) englobant les zones d'implantation (12, 13) et
- une deuxième étape avec un masquage permettant de séparer, à l'intérieur de cette zone active (9), les zones d'implantation différenciées (12, 13),
et en ce qu'on effectue
- ultérieurement à l'opération d'implantation des zones d'implantation (12, 13), une opération de recouvrement d'une partie des zones d'implantation (12, 13) et de la zone de séparation (11) avec un isolant déposé, cet isolant étant déposé contre la surface du substrat semi-conducteur à l'endroit de la zone de séparation (11).

**2 -** Procédé de réalisation d'un transistor bipolaire de protection contre des décharges électrostatiques dans un circuit intégré, comportant dans l'ordre
- des opérations de masquage permettant, pour ce transistor bipolaire, de délimiter en surface d'un substrat semi-conducteur deux zones d'implantation (12, 13) et une zone de séparation (11) entre les dites zones d'implantation (12, 13),
- une opération d'implantation des zones d'implantation (12, 13) avec des impuretés permettant de doper sélectivement ces zones d'implantation (12, 13),
caractérisé en ce que
- lors des opérations de masquage, on réalise un oxyde de champs ne couvrant pas les zones d'implantation (12, 13) et la zone de séparation (11) entre les zones d'implantation,
et en ce que
- la zone de séparation (11) entre les zones d'implantation (12, 13) est masquée temporairement lors de l'opération d'implantation, les seules zones d'implantation (12, 13) étant dopées lors de cette opération d'implantation.

**3 -** Transistor bipolaire de protection contre des décharges électrostatiques dans un circuit intégré, comportant
- un substrat semi-conducteur (15) implanté avec un dopant d'un premier type, dans une certaine concentration,
- une couche d'oxyde de champs (16) recouvrant une partie du substrat semi-conducteur (15) , la partie non recouverte formant une zone active,
- deux zones d'implantation distinctes (17) implantées avec un dopant d'un deuxième type dans la zone active,
- une zone de séparation, dans la zone active, entre ces zones d'implantation (17),
caractérisé en ce qu'il comporte
- une couche d'un isolant (19) déposé à la surface du transistor ultérieurement à l'implantation des zones d'implantation (17), cette couche d'isolant (19) étant au contact d'une partie des zones d'implantation (17) et de la zone de séparation,
et en ce que
l'isolant déposé (19) est au contact du substrat semi-conducteur (15) à l'endroit de la zone de séparation.

**4 -** Transistor suivant la revendication 3, caractérisé en ce que le substrat semi-conducteur (15) est implanté avec le dopant du premier type en concentration plus importante, dans sa partie recouverte par l'oxyde de champ (16), afin de créer un ou des murs d'isolation (21).

**5 -** Transistor suivant l'une des revendications 3 à 4, caractérisé en ce que le substrat semi-conducteur (15) est dépourvu d'une implantation avec le dopant de premier type en concentration plus importante au niveau de la zone de séparation.

**6 -** Transistor suivant la revendication 3, caractérisé en ce que
- la concentration du dopant de premier type est de 10¹⁶ impuretés/cm³, et
- la concentration du dopant de deuxième type est de 10¹⁹ à 10²⁰ impuretés/cm³.

**7 -** Transistor suivant la revendication 4, caractérisé en ce que la concentration de dopant de premier type dans les murs d'isolation (21) est de 10¹⁷ impuretés/cm³.

**8 -** Transistor suivant l'une des revendications 3 à 7, caractérisé en ce le dopant de premier type est de type P, et en ce que le dopant de deuxième type est de type N, et en ce que le transistor est du type NPN, le substrat semi-conducteur (15) constituant la base de ce transistor, et les deux zones d'implantation (17) et leurs diffusions sous-jacentes (18) constituant le collecteur et l'émetteur de ce transistor.
